# EUROPEAN PATENT APPLICATION

(11) **EP 2 184 790 A1**
(43) Date of publication of application: **12.05.2010**
(21) Application number: 09173906.0
(22) Date of filing: 23.10.2009
(51) Int. Cl.: H01L 33/64

(54) **Light emitting diode and llght source module having same**

(30) Priority: 10.11.2008 CN 200810305465
(71) Applicant: Foxsemicon Integrated Technology, Inc., Taiwan 350 (TW)
(72) Inventor: Lu, Ying-Chieh, Taiwan 350, Miao-Li Hsien (TW); Chiang, Kuo-Feng, Taiwan 350, Miao-Li Hsien (TW); Lai, Chih-Ming, Taiwan 350, Miao-Li Hsien (TW)
(74) Representative: Stuttard, Garry Philip

(57) **Abstract**

An exemplary light emitting diode includes a substrate (11), a metal material (1160) and a light emitting diode chip (12). The substrate (11) has a first surface (110) and a first through hole (116) defined in the first surface (110). The first through hole (116) is filled with the metal material (1160). The light emitting diode chip (12) is mounted on the first surface (110) contacting the metal material (1160) in the first through hole (116).

## Description

The present invention relates generally to light emitting diodes (LEDs) and particularly to an LED having high heat transfer efficiency and a light source module using the LED.

In recent years, due to excellent light quality and high luminous efficiency, light emitting diodes (LED) have increasingly been used to substitute for cold cathode fluorescent lamps (CCFL) as a light source of an illumination device, referring to "Solid-State Lighting: Toward Superior Illumination" by Michael S. Shur, or others. on proceedings of the IEEE, Vol. 93, NO. 10 (October, 2005).

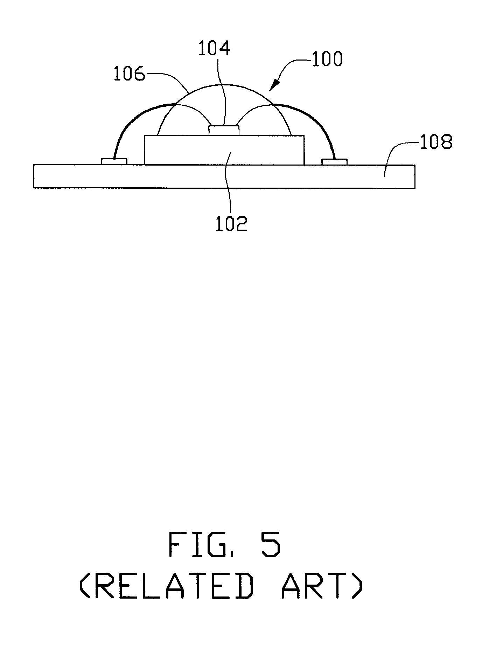

Referring to FIG. 5, a typical LED 100 includes a substrate 102, an LED chip 104 disposed on the substrate 102, and an encapsulant material 106 covering the LED chip 104. In operation, the LED 100 is mounted to a circuit board 108. The LED chip 104 emits light and generates heat therefrom. The light passes through the encapsulant material 106 to illuminate. The heat is transferred to the circuit board 108 by the substrate 102, and dissipated in the air. However, a conventional material of the substrate 102, such as fiberglass generally has high thermal resistance. Heat transfer efficiency of the LED 100 is limited due to the high thermal resistance of the substrate 102. Thus, the heat from the LED 100 can not be dissipated quickly, and light intensity of the LED 10 may be attenuated gradually, shortening life thereof.

What is needed, therefore, is an LED having high heat transfer efficiency which can overcome the limitations described, and a light source module using the LED.

According to an exemplary embodiment of the invention, an illumination device includes a substrate, a metal material and a light emitting diode chip. The substrate has a first surface and a first through hole defined in the first surface. The first through hole is filled with the metal material. The light emitting diode chip is mounted on the first surface contacting the metal material in the first through hole.

Other advantages and novel features of the disclosure will be drawn from the following detailed description of the exemplary embodiments of the disclosure with attached drawings.

FIG. 1 is cross-section of a LED, in accordance with a first embodiment.

FIG 2 is cross-section of a LED, in accordance with a second embodiment.

FIG. 3 is cross-section of a LED, in accordance with a third embodiment.

FIG. 4 is cross-section of a light source module according to a fourth embodiment using a plurality of LEDs in FIG. 1.

FIG. 5 is a schematic view of a typical LED.

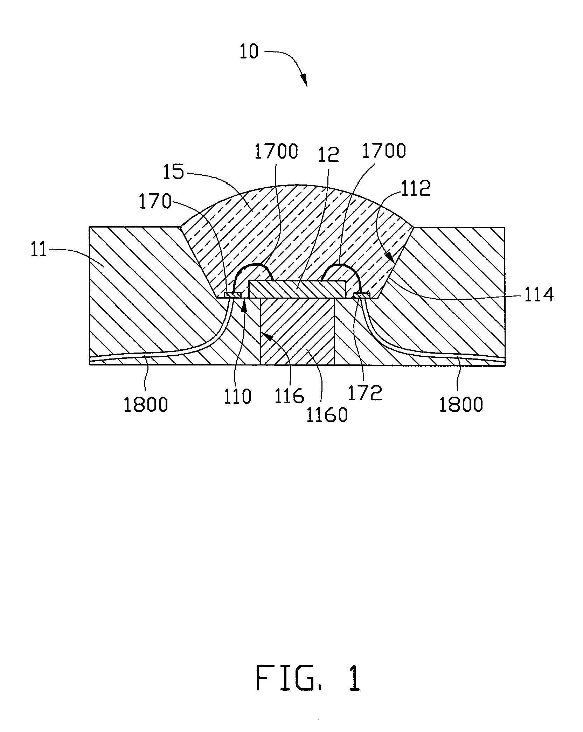

Referring to FIG. 1, a LED 10 in accordance with a first embodiment is shown. The LED 10 includes a substrate 11, an LED chip 12, and an encapsulant material 15.

The substrate 11 supports the LED chip 12 and the encapsulant material 15 thereon, and may be made of ceramic material, which has good electrical insulation property. The ceramic material can be comprised of a mixture of silicon oxide (SiO₂) and aluminum oxide (Al₂O₃). The substrate 11 includes a first surface 110 and a second surface 112 surrounding the first surface 110. The second surface 112 connects with the first surface 110 to cooperatively form an accommodating space 114 for receiving the LED chip 12. The substrate 11 has at least one first through hole 116 defined in the first surface 110 to communicate with the accommodating space 114. In the first embodiment, one first through hole 116 is defined and filled with a first thermally conductive material 1160. The first thermally conductive material 1160 may be metal material, such as copper, silver, etc.

The LED chip 12 is mounted directly on the first surface 110 of the substrate 11 to contact the first thermally conductive material 1160 in the first through hole 116. Thereby the first thermally conductive material 1160 in the first through hole 116, together with the substrate 11 can transfer the heat generated by the LED chip 12 to the outside of the LED 10. In this manner, the LED chip 12 may operate continually within an acceptable temperature range to achieve stable optical performance, and the brightness and the luminous efficiency of the LED 10 are stably maintained. The first thermally conductive material 1160 in this embodiment is silver, which has a high heat transfer coefficient of about 430W/mk, and has anti-oxidation characteristic. To prevent the first thermally conductive material 1160 and the ceramic material of the substrate 11 expanding and crushing one another if unevenly heated, in the first embodiment, the ceramic material of the substrate 11 has a thermal expansivity in a range from about 5.8 ppm/°C to about 6.2 ppm/°C, and the first thermally conductive material 1160 has a thermal expansivity in a range from about 7 ppm/°C to about 10 ppm/°C, which is near to that of the ceramic material.

The LED 10 further includes a positive electrode 170 and a negative electrode 172 formed on the first surface 110. The LED chip 12 is electrically connected to the positive electrode 170 and the negative electrode 172 each through a first wire 1700, and each first wire 1700 is further connected to an exterior power supply (not shown) having an anode and a cathode through a second wire 1800 (encapsulated in the substrate 11 in FIG. 1). Thereby, electric current can be applied to the LED chip 12.

The encapsulant material 15 is disposed on the first surface 110 of the substrate 11 to fill the accommodating space 114 and cover the LED chip 12, as well as the positive electrode 170 and the negative electrode 172. The encapsulant material 15 is configured for optically adjusting (e.g., diverging or converging) a direction of the light emitted from the LED chip 12, thus adjusting an illuminating scope of the LED 10. In addition, the encapsulant material 15 protects the LED chip 12 from contaminants. The encapsulant material 15 is arc-shaped in this embodiment.

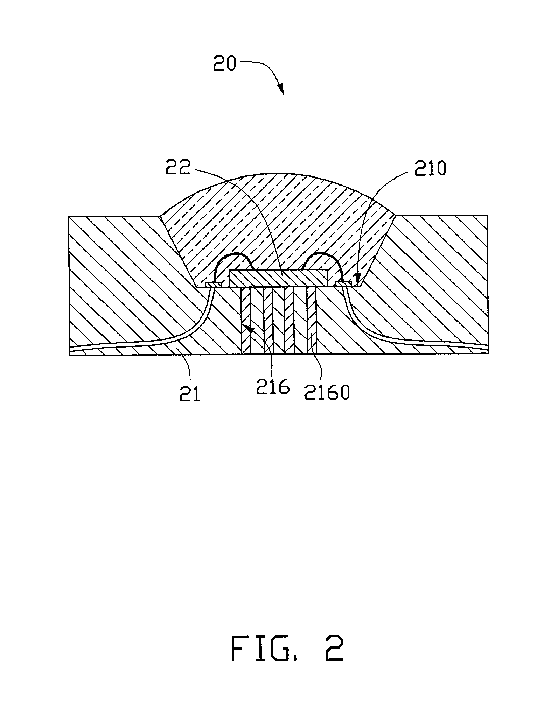

Referring to FIG. 2, an LED 20, in accordance with a second embodiment, is shown. The LED 20 is similar to the LED 10 in the first embodiment except that a substrate 21 has four first through holes 216 defined in a first surface 210 thereof. The four first through holes 216 are parallel with one another, and each is filled with a first thermally conductive material 2160 contacting the LED chip 22.

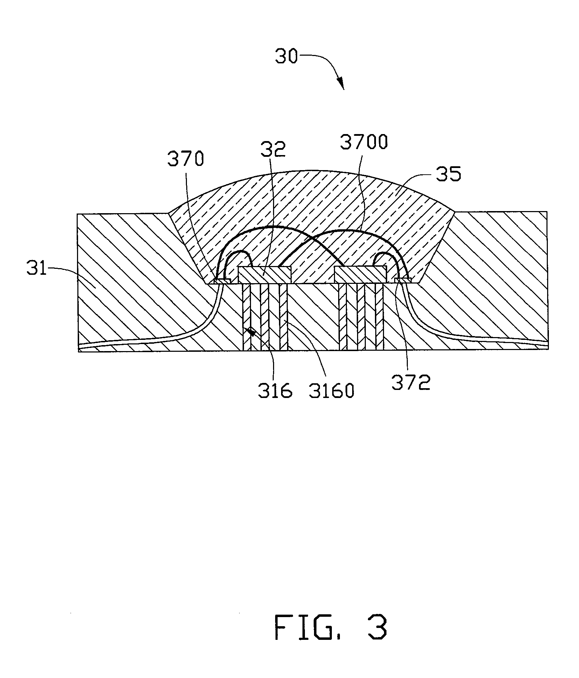

FIG. 3 illustrates an LED 30 according to a third embodiment. The LED 30 is similar to the LED 20 in the second embodiment except that the LED 30 includes two LED chips 32 disposed on a substrate 31 and adjacent to one another. The two LED chips 32 are each electrically connected to a positive electrode 370 and a negative electrode 372 through a first wire 3700. In addition, the substrate 31 has six first through holes 316 defined in a first surface 310 thereof. Each LED chip 22 contacts a thermally conductive material 3160 through several of the first through holes 316, for example, through three first through holes 316.

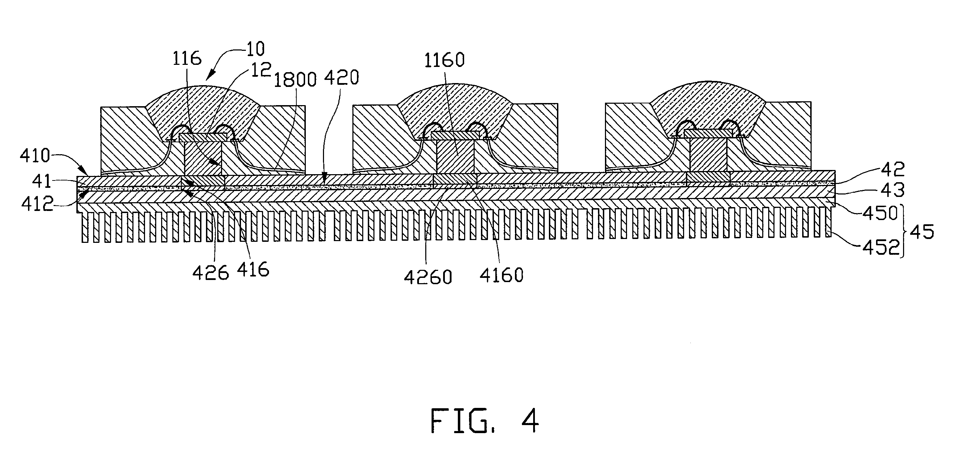

Referring to FIG. 4, a light source module 40, in accordance with a fourth embodiment, is shown. The light source module 40 includes a circuit board 41, a plurality of LEDs 10 mounted on the circuit board 41, and a heat dissipation plate 43 contacting the circuit board 41.

The LEDs 10 according to the fourth embodiment all have a same structure as the LED 10 in the first embodiment. Therefore, for the purpose of brevity, the LEDs 10 in the fourth embodiment are not further described herein with the understanding that like reference numbers of the LED 10 in the first embodiment refer to like parts in the LEDs 10 in the fourth embodiment. The LEDs 10 in the fourth embodiment are used as a light source for illumination. In alternative embodiments, the LEDs in the fourth embodiment can be the LEDs 20 from the second embodiment and/or the LEDs 30 from the third embodiment.

The circuit board 41 can be a ceramic circuit board, or a fiberglass circuit board (FR4). The circuit board 41 includes a third surface 410 and an opposite fourth surface 412. The LEDs 10 are arranged on the third surface 410 and electrically coupled to the circuit board 41 by connecting the second wires 1800 to the circuit board 41 (not shown).

The circuit board 41 has a plurality of second through holes 416 defined in the third surface 410 corresponding to the first through holes 116. Each second through hole 416 is filled with a second thermally conductive material 4160 contacting the first thermally conductive material 1160 in the corresponding first through hole 116.

The heat dissipation plate 43 is coupled to the circuit board 41 through a bonding sheet 42. The bonding sheet 42 may be an insulated adhesive layer coated between the fourth surface 412 and the heat dissipation plate 43, and has a surface 420 coinciding with the fourth surface 412. The bonding sheet 42 has a plurality of third through holes 426 defined in the surface 420 corresponding to the second through holes 416. Each third through hole 426 is filled with a third thermally conductive material 4260 contacting the second thermally conductive material 4160 in the corresponding second through hole 416, and the heat dissipation plate 43. The first, the second, and the third thermally conductive materials 1160, 4160 and 4260 each can be metal material with high thermal conductivity, such as silver, silver alloy, or others. The heat dissipation plate 43 can be made of metal, such as copper, aluminum, or others. In operation, heat from each LED 10 can be transferred in sequence from the first thermally conductive material 1160, the corresponding second thermally conductive material 4160, and the corresponding third thermally conductive material 4260 to the heat dissipation plate 43. The heat then can be dissipated efficiently by the heat dissipation plate 43 to the air. It is noted, that a diameter of each second through hole 416 is larger than that of the corresponding first through hole 116. Thereby ensuring a contacting surface of the first thermally conductive material 1160 in each first through hole 116 completely contacts the second thermally conductive material 4160 in the corresponding second through holes 416. The heat may be fully transferred from the first thermally conductive material 1160 to the second thermally conductive material 4160. Similarly, a diameter of each third through hole 426 is preferably larger than that of the corresponding second through hole 416. Thus the heat may be fully transferred from the second thermally conductive material 4160 to the third thermally conductive material 4260.

The light source module 40 can further include a heat dissipation device 45 to enhance heat dissipation efficiency. For example, the heat dissipation device 45 may include a base 450 contacting an opposite side of the heat dissipation plate 43 to bonding sheet 42, and a plurality of fins 452 extending from the base 450. Heat can be further transferred from the heat dissipation plate 43 to the fins 452 through the base 450. The fins 452 increase surface area contacting the air. Thus, if there is a need, more heat can be dissipated to the air.

It is believed that the exemplary embodiments and their advantages will be understood from the foregoing description, and it will be apparent that various changes may be made thereto without departing from the spirit and scope of the disclosure or sacrificing all of its material advantages, the examples hereinbefore described merely being preferred or exemplary embodiments of the disclosure.

## Claims

1. A light emitting diode comprising:
a substrate having a first surface and a first through hole defined in the first surface, and a metal material, wherein the first through hole is filled with the metal material; and
a light emitting diode chip mounted on the first surface contacting the metal material in the first through hole.

2. A light emitting diode as claimed in claim 1, wherein a material of the substrate is comprised of a mixture of silicon oxide and aluminum oxide.

3. A light emitting diode as claimed in claim 1, wherein the metal material in the first through hole is one of silver and silver alloy.

4. A light emitting diode as claimed in any preceding claim wherein the substrate has a thermal expansivity in the range about 5.8 ppm/°C to about 6.2 ppm/°C and the metal material has a thermal expansivity in the range about 7 ppm/°C to about 10 ppm/°C.

5. A light emitting diode as claimed in any preceding claim wherein the substrate further comprises a second surface connecting with the first surface, wherein the first and the second surfaces cooperatively form an accommodating space for receiving the light emitting diode chip.

6. A light emitting diode comprising:
a substrate having a first surface and a first through hole defined in the first surface, and a metal material, wherein the substrate is comprised of a mixture of silicon oxide and aluminum oxide and the first through hole is filled with the metal material;
a light emitting diode chip mounted on the first surface contacting the metal material in the first through hole.

7. A light emitting diode as claimed in claim 6 wherein the metal material in the first through hole is one of silver and silver alloy.

8. A light emitting diode as claimed in claim 6 or 7 wherein the substrate has a thermal expansivity in the range about 5.8 ppm/°C to about 6.2 ppm/°C and the metal material in the first through hole has a thermal expansivity in the range about 7 ppm/°C to about 10 ppm/°C.

9. A light emitting diode as claimed in any of claims 6 to 8, wherein the substrate further comprises a second surface connecting with the first surface, wherein the first and the second surfaces cooperatively form an accommodating space for receiving the light emitting diode chip.

10. A light source module comprising:
a light emitting diode comprising:
a substrate having a first surface and a first through hole defined in the first surface, and a first metal material, wherein the substrate is comprised of a mixture of silicon oxide and aluminum oxide and the first through hole is filled with the first metal material,
a light emitting diode chip mounted on the first surface contacting the first metal material in the first through hole;
a circuit board having a third surface for mounting the light emitting diode thereon and a second through hole defined in the third surface, and a second metal material, wherein the second through hole is filled with the second metal material contacting the first metal material in the first through hole;
a heat dissipation plate coupled to an opposite side of the circuit board to the light emitting diode.

11. A light source module as claimed in claim 10 further comprising a bonding sheet, wherein the heat dissipation plate is coupled to the circuit board via the bonding sheet.

12. A light source module as claimed in claim 11, wherein the bonding sheet is an insulated adhesive layer.

13. A light source module as claimed in claim 11, wherein the bonding sheet has a third through hole defined therein, and a third metal material, wherein the third through hole is filled with the third metal material contacting the second metal material in the second through hole.

14. A light source module as claimed in claim 13, wherein the first, second and third metal material are selected from the group consisting of silver and silver alloy.

15. A light source module as claimed in claim 10 further comprising a heat dissipation device which comprises a base contacting the heat dissipation plate and a plurality of fins extending from the base.

16. A light source module as claimed in any of claimc 10 to 15, wherein the substrate has a thermal expansivity in the range about 5.8 ppm/°C to about 6.2 ppm/°C and the metal material in the first through hole has a thermal expansivity in the range about 7 ppm/°C to about 10 ppm/°C.

17. A light source module as claimed in any of claims 10 to 16, wherein the substrate further comprises a second surface connecting with the first surface, wherein the first and the second surfaces cooperatively form an accommodating space for receiving the light emitting diode chip.
